# EUROPEAN PATENT APPLICATION

(11) **EP 4 401 528 A1**
(43) Date of publication of application: **17.07.2024**
(21) Application number: 22867175.6
(22) Date of filing: 22.08.2022
(51) Int. Cl.: H10K 30/80

(54) **PEROVSKITE SOLAR CELL**

(30) Priority: 07.09.2021 JP 2021145813
(71) Applicant: Enecoat Technologies Co.,Ltd., Kyoto 613-0031 (JP)
(72) Inventor: TOKUDA Rie, Kuse-gun, Kyoto 613-0031 (JP); TAKAHAMA Tsuyoshi, Kuse-gun, Kyoto 613-0031 (JP)
(74) Representative: Peters, Sebastian Martinus
(86) International application number: PCT/JP2022/031500
(87) International publication number: WO 2023/037853

(57) **Abstract**

[Problem] To provide a perovskite solar cell which is prevented from penetration of moisture or oxygen into the device, thereby having high durability. [Solution] A solar cell (1) which comprises a supporting body (11), a solar cell element (12) that is provided on the supporting body (11), an adhesive layer (13) that covers the entirety of the solar cell element (12), a sealant layer (14) that covers the entirety of the adhesive layer (13), and a sealing part (15) that is provided on an end region of the sealant layer (14) so as to cover the end region. With respect to this solar cell (1), the solar cell element (12) sequentially comprises a transparent electrode, a photoelectric conversion layer that contains a perovskite compound, and a backside electrode in this order; and the distance (d1) between an end of the solar cell element (12) and an end of the adhesive layer (13) is 0.5 mm to 2 cm.

## Description

### TECHNICAL FIELD

The present invention relates to a perovskite solar cell.

### BACKGROUND ART

Perovskite solar cells are weak in water, and the issue to be solved of perovskite solar cells is to make a device structure such that water does not enter into the device. WO2018/052032 describes a structure in which the entire side surfaces of an organic insulating layer covering the entire perovskite solar cell are sealed. Since water is likely to intrude into this device through the organic insulating layer provided between a flexible substrate made of metal foil and a transparent electrode, the organic insulating layer is sealed with a barrier layer. However, the problem of water intruding through the interface between the barrier layer and the transparent electrode is not solved.

### CITATION LIST

### PATENT LITERATURE

Patent Literature 1: WO2018/052032

### SUMMARY OF INVENTION

### TECHNICAL PROBLEM

The present invention has an object of providing a perovskite solar cell with high durability.

### SOLUTION TO PROBLEMS

A solar cell described herein includes a support body, a solar cell element provided on the support body, an adhesive layer covering the solar cell element, a sealant layer covering the adhesive layer, and a sealing part that is provided in an end region of the sealant layer and covers the end region.

The solar cell element includes an electrode, a photoelectric conversion layer containing a perovskite compound, and a back electrode, in this order.

In the solar cell described above, a distance (d1) between an end portion of the solar cell element and an end portion of the adhesive layer is preferably 0.5 mm or more and 2 cm or less.

In the solar cell described above, a distance (d2) between an end portion of the adhesive layer and an end portion of the sealant layer is preferably 0.2 mm or more and 1 cm or less.

In the solar cell described above, a distance (d3) between an end portion of the sealant layer and an end portion of the sealing part is preferably 0.5 mm or more and 1.5 cm or less.

In the solar cell described above, the sealing part is preferably opaque.

### ADVANTAGEOUS EFFECTS OF INVENTION

According to the present invention, it is possible to provide a perovskite solar cell that prevents intrusion of water and has high durability.

### BRIEF DESCRIPTION OF DRAWINGS

[FIG. 1] FIG. 1 is a conceptual diagram illustrating an example of a cross-sectional view of a solar cell of the present invention.
[FIG. 2] FIG. 2 is a conceptual diagram illustrating an example of a top view of the solar cell of the present invention.
[FIG. 3] FIG. 3 is a conceptual diagram illustrating an example of a cross-sectional view of a solar cell of the present invention.
[FIG. 4] FIG. 4 is a conceptual diagram illustrating an example of a cross-sectional view of a solar cell of the present invention.
[FIG. 5] FIG. 5 is a conceptual diagram illustrating an example of a structure of a perovskite solar cell element (direct).
[FIG. 6] FIG. 6 is a conceptual diagram illustrating an example of a structure of a perovskite solar cell element (inverted).
[FIG. 7] FIG. 7 is a conceptual diagram illustrating a cross-sectional view of a solar cell of an experimental example.

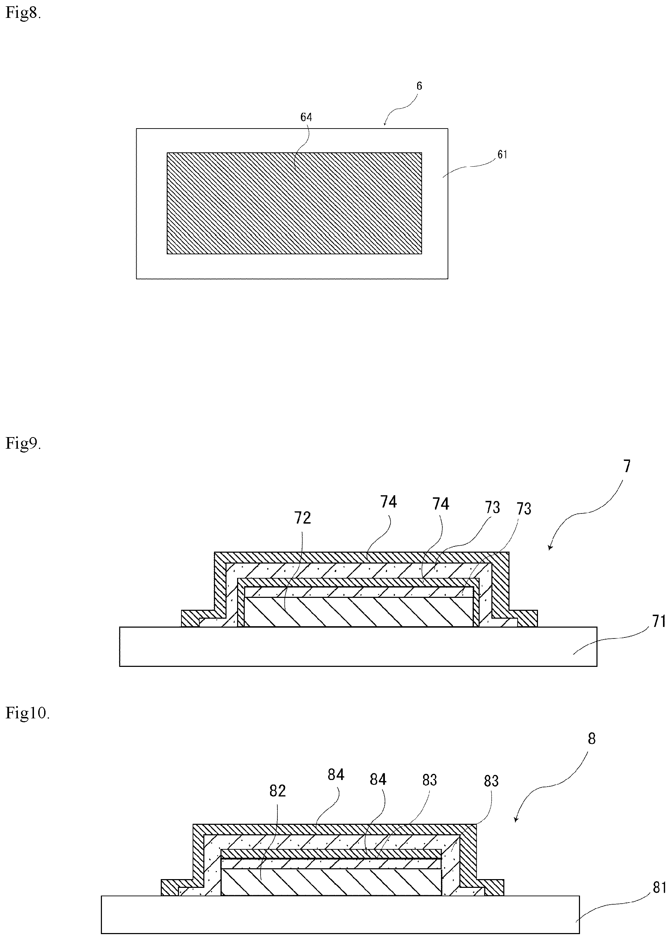

[FIG. 8] FIG. 8 is a conceptual diagram illustrating a top view of the solar cell of the experimental example.
[FIG. 9] FIG. 9 is a conceptual diagram illustrating an example of a cross-sectional view of a solar cell of an experimental example.
[FIG. 10] FIG. 10 is a conceptual diagram illustrating an example of a cross-sectional view of a solar cell of an experimental example.

### DESCRIPTION OF EMBODIMENTS

Hereinafter, embodiments for carrying out the present invention will be described with reference to the drawings. The present invention is not limited to the following embodiments and includes modifications of the following embodiments made by a person skilled in the art as appropriate to the extent obvious.

### Solar Cell

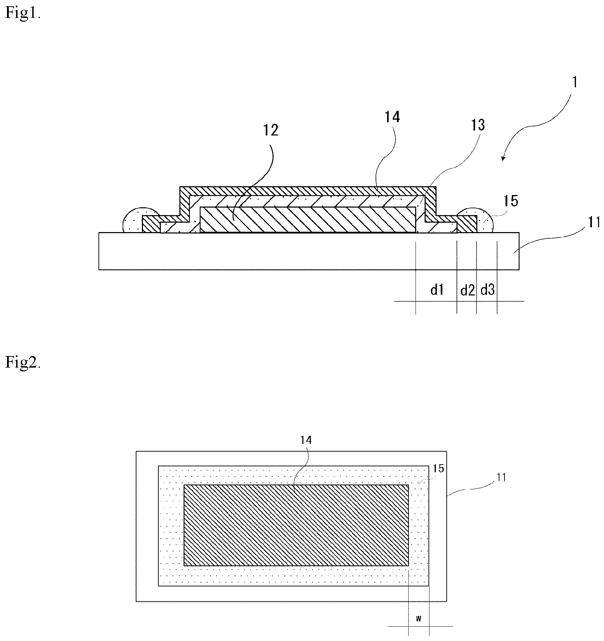

A first aspect of the invention relates to a solar cell. FIGS. 1, 3, and 4 are cross-sectional views of solar cells, and FIG. 2 is a conceptual diagram illustrating a top view of the solar cell illustrated in FIG. 1. As illustrated in FIGS. 1 to 4, the solar cells 1, 2, and 3 includes first support bodies 11, 21, and 31, (perovskite) solar cell elements 12, 22, and 32, adhesive layers 13, 23, and 33, sealant layers (main body parts) 14, 24, and 34 covering the entire adhesive layer, and sealing parts 15, 25, and 35, respectively.

### Support Bodies 11, 21, and 31

As the support bodies 11, 21, and 31, a publicly known substrate in an organic solar cell or an organic EL element can be used as appropriate. Examples of the substrate include glass, plastic plate, plastic film, inorganic crystal, and others. At least one of metal film, semiconductor film, conductive film, and insulating film may be preferably formed on the partial or entire surface of the substrate. In particular, the support body preferably has a flexible substrate for thickness reduction and lighter weight.

### Solar Cell Elements 12, 22, and 32

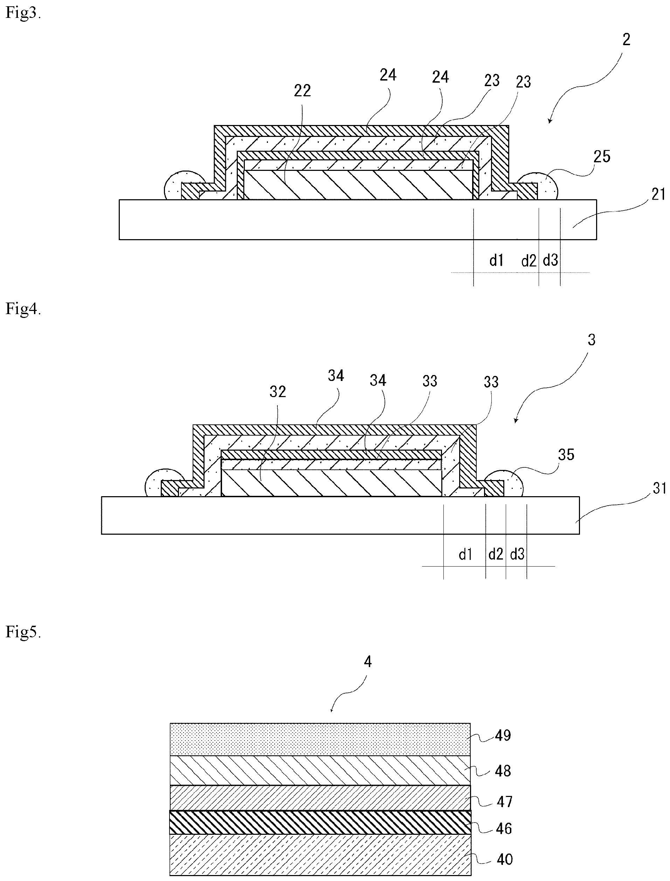

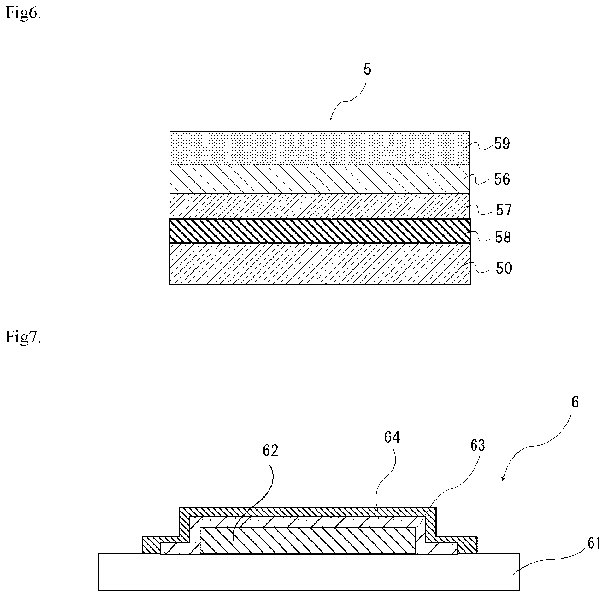

The solar cell element refers to an element that has the function of generating electricity from light such as sunlight. The solar cell element preferably has a shape in which a perovskite layer (light absorption layer/photoelectric conversion layer) is sandwiched between an electron transport layer and a hole transport layer. The perovskite layer is preferably a perovskite layer made of an organic-inorganic hybrid compound. As illustrated in FIG. 5, the solar cell element may have a direct structure in which an electron transport layer 46, a perovskite layer 47, a hole transport layer 48, and a back electrode 49 are formed in order from a transparent electrode 40 side. Alternatively, as illustrated in FIG. 6, the solar cell element may have an inverted structure in which a hole transport layer 58, a perovskite layer 57, an electron transport layer 56, and a back electrode 59 are formed in order from a transparent electrode 50 side.

### Electrodes 40 and 50

The electrode is preferably a transparent electrode to transmit light. The transparent electrode is the support body of the electron transport layer and also has the function of taking electrons out of the perovskite layer (light absorption layer/photoelectric conversion layer). The electrode is formed on the support bodies 11, 21, and 31. The transparent electrode is made of a conductor. Specific examples of the transparent electrode include a tin-doped indium oxide (ITO) film, an impurity-doped indium oxide (In2O3) film, an impurity-doped zinc oxide (ZnO) film, a fluorine-doped tin dioxide (FTO) film, a laminated film made by laminating the foregoing films, gold, silver, copper, aluminum, tungsten, titanium, chrome, nickel, cobalt, and others. They may be used singly or in a mixture of two or more thereof, or may be provided as a single layer or a laminated layer. These films may function as a diffusion-preventive layer, for example. The thickness of these electrodes is not limited in particular, and is preferably adjusted such that the sheet resistance is 5 to 15Ω/□ (per unit area) . The electrodes can be obtained by a publicly known film forming method in accordance with the forming material. These electrodes may be formed in a film form or a grid form such as a mesh. The method for forming the electrode on the support body may be a publicly known method, and is preferably a vacuum film formation such as vacuum evaporation or sputtering. The transparent electrodes may be patterned, and examples of a patterning method include using laser, immersing in an etching liquid, patterning with a mask at the time of vacuum film formation. In the present invention, any of these methods may be used.

### Electron Transport Layers 46 and 56

The electron transport layers 46 and 56 are preferably electron transport semiconductors. Examples of the electron transport layers 46 and 56 include metal chalcogenides such as oxides of titanium, tin, zinc, iron, tungsten, zirconium, indium, cerium, yttrium, aluminum, magnesium, vanadium, and niobium, sulfides of cadmium, zinc, lead, silver, antimony, and bismuth, selenides of cadmium and lead, and telluride of cadmium. Among them, oxides are preferred in particular. Among them, zinc oxide, tin oxide, and titanium oxide are preferred in particular. The electron transport layer may be a single layer or a multi-layer. In the case of a multi-layer, the electron transport layer may have a porous shape in which semiconductor fine particles different in particle diameter are applied in a multi-layered manner. In the case of a porous shape, the particle diameter of the semiconductor fine particles is preferably 3 to 100 nm, more preferably 5 to 70 nm. The film thickness is preferably 5 to 1000 nm, more preferably 10 to 500 nm.

The method for forming the electron transport layer is not limited in particular. Any of vacuum film forming methods such as sputtering and ion plating and wet film forming methods such as a sol-gel method may be used.

### Hole Transport Layers 48 and 58

The hole transport layers 48 and 58 are layers that have the function of transporting electric charge. For the hole transport layer, a conductor, a semiconductor, an organic hole transport material, or the like can be used, for example. The material can function as a hole transport material that receives holes from the perovskite layer (light absorption layer) and transports the holes. Examples of the conductor and semiconductor include chemical compounds containing monovalent coppers such as CuI, CuInSe₂, and CuS; and compounds containing metals other than copper, such as GaP, NiO, CoO, FeO, Bi₂O₃, MoO₂, and Cr₂O₃. Among them, a semiconductor containing a monovalent copper is preferred, and CuI is more preferred, from the viewpoint of more efficiently receiving only the holes and obtaining a higher degree of hole mobility. Examples of the organic hole transport material include polythiophene derivatives such as poly-3-hexylthiophene (P3HT) and polyethylene-dioxythiophene (PEDOT); fluorene derivatives such as 2,2',7,7'-tetrakis-(N,N-di-p-methoxyphenylamine)-9,9'-spirobifluorene (Spiro-OMeTAD); carbazole derivatives such as polyvinyl carbazole; triphenylamine derivatives such as poly[bis(4-phenyl)(2,4,6-trimethylphenyl)amine] (PTAA); diphenylamine derivatives; polysilane derivatives; polyaniline derivatives, and others. Among them, triphenylamine derivatives, fluorene derivatives, and the like are preferred, and PTAA and Spiro-OMeTAD are more preferred, from the viewpoint of more efficiently receiving only the holes and obtaining a higher degree of hole mobility.

For the purpose of further improving the hole transport characteristics, the hole transport layer may contain oxidants such as lithium bis(trifluoromethylsulfonyl) imide (LiTFSI), silver bis(trifluoromethylsulfonyl)imide, trifluoromethylsulfonyloxy silver, NOSbF6, SbCl5, SbF5, and tris(2-(1H-pyrazole-1-yl)-4-tert-butylpyridine)cobalt(III)tri[bis(trifluoromethane)sulfonimide] . The hole transport layer may also contain basic compounds such as t-butylpyridine (TBP), 2-picoline, and 2,6-lutidine. The contents of the oxidant and basic compound can be set to the conventionally used amounts. The film thickness of the hole transport layer is preferably 50 to 800 nm and more preferably 100 to 600 nm, for example, from the viewpoint of more efficiently receiving only the holes and obtaining a higher degree of hole mobility. The method for forming the hole transport layer is not limited in particular and the hole transport layer can be formed according to a publicly known method. Examples of the method for forming the hole transport layer include wet film forming methods such as dipping, spraying, spin-coating, and blade-coating, and vacuum film forming methods such as sputtering.

### Perovskite Layer (Light Absorption Layer/Photoelectric Conversion Layer) 47, 57

The perovskite layers (light absorption layers/photoelectric conversion layers) 47 and 57 are layers that perform photoelectric conversion by absorbing light and moving excited electrons and holes. The perovskite compound in the present invention is preferably a complex substance of an organic compound and an inorganic compound. The perovskite compound preferably exhibits a layered perovskite structure in which layers made of a halogenated metal and layers with alignment of organic cation molecules are alternately laminated, which is expressed by the following general formula (1):

XαYβMγ ... general formula (1)

In the foregoing general formula (1), X indicates a halogen atom, Y indicates an alkyl amin compound, M indicates at least one or more kinds of metallic ion selected from among lead, tin, indium, antimony, and bismuth, the ratio of α:β:γ is 3:1:1, and β and γ indicate integers of larger than 1. Examples of X include halogen atoms of chlorine, bromine, iodine, and the like, which can be used singly or in a mixture. Examples of Y include alkyl amin compounds such as methylamine, ethylamine, n-butylamine, and formamidine.

The flatness of the perovskite layer preferably has a height difference of 50 nm or less (-25 nm to +25 nm), more preferably a height difference of 40 nm or less (-20 nm to +20 nm) in an area of 500 nm × 500 nm in the horizontal direction of the surface measured by a scanning electron microscope. This makes it easy to strike a balance between the light absorption efficiency and the exciton diffusion length and further improves the light absorption efficiency.

Examples of the method for forming the perovskite layer include a one-step precipitation method by which a solution in which halogenated metals and halogenated alkylamines are dissolved or dispersed is applied to the electron-transport layer or the hole transport layer and dried or a two-step precipitation method by which a solvent in which halogenated metals are dissolved or dispersed is applied to the electron transport layer or the hole transport layer and dried, and then the layer is immersed in a solution in which halogenated alkylamines are dissolved in a solvent. In addition, in the one-step precipitation method, a solvent not dissolving a perovskite compound can be added before the full application of the solution to promote crystallization in a stroke.

After the formation of the perovskite compound layer, a solution in which a halogenated amine compound is dissolved may be further applied to the perovskite layer. Example of the halogenated amine compound used at this time include phenyl ethylamine bromide, phenyl ethylamine iodide, n-hexyltrimethylamine bromide, n-octadecylamine iodide, 5-ammonium valeric acid iodide, and others, and they may be used singly or in a mixture of two or more thereof.

### Back Electrodes 49 and 59

Examples of the back electrodes 49 and 59 include metals such as platinum, gold, silver, copper, aluminum, rhodium, nickel, cobalt, iron, palladium, and indium, carbon compounds such as graphite, graphene, and carbon nanotube, electroconductive metal oxides such as ITO, indium-doped zinc oxide (IZO), antimony-doped tin oxide (ATO), or electroconductive polymers such as polythiophene or polyaniline, and they may be used singly or in a mixture of two or more thereof. The back electrodes may be transparent electrodes. The film thickness of the back electrodes is not limited in particular and maybe a single film of any of the foregoing materials or may be a mixed or laminated film of two or more of the foregoing materials. The back electrode can be formed by using a method such as coating, laminating, vacuum evaporation, CVD, or sticking to the hole transport layer as appropriate, depending on the kind of the material used or the type of the hole transport layer.

### Adhesive Layers 13, 23, and 33

The adhesive layers are layers that cover the solar cell element. The adhesive layer may cover the entire solar cell element or may cover the partial solar cell element. The adhesive layer is a layer that is arranged between the support body and the sealant layer (the main body part). The adhesive layer is used to bond the support body and the sealant layer together and also bond the support body-like solar cell element and the sealant layer together. If the adhesive layer covers the entire solar cell element, the adhesive layer also has the function of sealing the solar cell element. The material of the adhesive is not limited in particular and can be selected as appropriate according to the purpose. Examples of the material include cured materials of an acrylic resin, an epoxy resin, and the like.

The cured material of an acrylic resin may be any of publicly known materials as far as it is formed by curing a monomer or oligomer having an acryl group in molecules. The cured material of an epoxy resin can be any of publicly known materials as far as it is formed by curing a monomer or oligomer having an epoxy group in molecules.

Examples of the epoxy resin include a water-dispersion type, a solventless type, a solid type, a heat-curable type, a hardener-mixed type, an ultraviolet-curable type, and others. Among them, a heat-curable type and an ultraviolet-curable type are preferred, and an ultraviolet-curable type is more preferred. Even in the case of using an ultraviolet-curable type, the material can be heated and is preferably heated even after ultraviolet curing. Specific examples of the epoxy resin include a bisphenol A type, a bisphenol F type, a novolac type, a cycloaliphatic type, a long-chain aliphatic type, a glycidyl amine type, a glycidyl ether type, a glycidyl ester type, and others, and they may be used singly or in a combination of two or more thereof. The epoxy resin is preferably mixed with a hardener and various additives as necessary. Commercially available epoxy resin compositions can be used in the present invention. Among them, some epoxy resin compositions have been developed and commercialized for solar cells and organic EL elements, and they can be effectively used in particular in the present invention. Examples of the commercially available epoxy resin compositions include TB3118, TB3114, TB3124, and TB3125F (produced by ThreeBond Co., Ltd.), World Rock5910, World Rock5920, and World Rock8723 (produced by Kyoritsu Chemical & Co., Ltd.), WB90US(P) (produced by MORESCO Corporation), and others.

The hardener is not limited in particular, and can be selected as appropriate in accordance with the purpose. Examples of the hardener include amin-based, acid anhydride-based, polyamide-based, and other hardeners. Examples of the amin-based hardener include aliphatic polyamines such as diethylene triamine and triethylenetetramine, aromatic polyamines such as meta-phenylene diamine, diaminodiphenyl methane, and diaminodiphenylsulfone. Examples of the acid anhydride-based hardener include phthalic anhydride, tetra and hexahydrophthalic anhydride, methyltetrahydrophthalic anhydride, methylnadic anhydride, pyromellitic anhydride, het anhydride, dodesenyl succinic anhydride, and others. Examples of the other hardeners include imidazoles, polymercaptan, and others. They may be used singly or in a combination of two or more thereof.

The additives are not limited in particular and can be selected as appropriate in accordance with the purpose. Examples of the additives include a filling material (filler), a gap agent, a polymerization initiator, a drying agent (hygroscopic agent), a curing accelerator, a coupling agent, a flexibilizer, a colorant, a flame retardant aid, an antioxidant, an organic solvent, and others. Among them, a filling material, a gap agent, a curing accelerator, a polymerization initiator, and a drying agent (hygroscopic agent) are preferred, and a filling material and a polymerization initiator are more preferred. The inclusion of a filling material as an additive makes it possible to suppress intrusion of water and oxygen and further obtain advantageous effects such as reducing the volume contraction at the time of curing, decreasing the amount of outgassing at the time of curing or heating, improving the mechanical strength, and controlling the thermal conductivity and fluidity. Therefore, the inclusion of a filling material as an additive is very effective in maintaining the stable output in various environments. The additives may be added to the sealant layer and the sealing part.

With regard to the output characteristics and durability of the solar cell element, not only the influence of intruding water and oxygen but also the influence of outgassing at the time of curing or heating the sealant member are not negligible. In particular, the outgassing at the time of heating greatly affects the output characteristics of the solar cell element in storage under high-temperature environments. The inclusion of a filling material, a gap agent, and a drying agent in the adhesive layer, the sealant layer, and the sealing part suppresses the intrusion of water and oxygen into these layers and decreases the use amounts of the adhesive and sealant, thereby achieving the effect of reducing the outgassing. The inclusion of a filling material, a gap agent, and a drying agent in the adhesive layer, the sealant layer, and the sealing part is also effective in storing the solar cell element under high-temperature environments.

The filling material is not limited in particular and can be selected as appropriate in accordance with the purpose. Examples of the filling material include silicate minerals such as crystalline or amorphous silica and talc, and inorganic filling materials such as alumina, aluminum nitride, silicon nitride, calcium silicate, and calcium carbonate. Among them, hydrotalcite is preferred in particular. They may be used singly or in a combination of two or more thereof.

The average primary particle diameter of the filling material is preferably 0.1 um or more and 10 um or less, more preferably 1 um or more and 5 um or less. With the average primary particle diameter of the filling agent within the foregoing preferred range, it is possible to sufficiently obtain the effect of suppressing the intrusion of water and oxygen, achieve the proper viscosity, and improve the adhesion to the substrate and the defoaming property, which is also effective in controlling the width of the sealing part and improving workability.

The content of the filling agent in the entire adhesive layer (100 parts by mass) is preferably 10 parts by mass or more and 90 parts by mass or less, more preferably 20 parts by mass or more and 70 parts by mass or less. With the content of the filling material within the foregoing preferred range, it is possible to sufficiently obtain the effect of suppressing the intrusion of water and oxygen, achieve the proper viscosity, and attain the favorable adhesion and workability.

The gap agent is also called gap control agent or spacer agent. The inclusion of the gap material as an additive makes it possible to control a gap in the sealing part. For example, if the adhesive layer is applied to the first substrate or the first electrode and the second substrate is placed on the adhesive layer and sealed, the adhesive layer or the sealant layer is mixed with the gap agent and thus the gap in the sealing part conforms to the size of the gap agent. Accordingly, it is easy to control the gap in the sealing part.

The gap agent is not limited in particular as far as it is granular, uniform in particle diameter, and high in resistance to solvents and heat, and can be selected as appropriate in accordance with the purpose. The gap agent preferably has high compatibility with epoxy resins and has a circular particle shape. Specifically, the gap agent is preferably glass beads, silica fine particles, organic resin fine particles, and the like. They may be used singly or in a combination of two or more thereof.

The particle diameter of the gap agent can be selected in accordance with the gap in the sealing part to be set, and is preferably 1 um or more and 100 um or less, more preferably 5 um or more and 50 um or less.

The polymerization initiator is not limited in particular as far as it initiates polymerization using heat or light, and can be selected as appropriate in accordance with the purpose. Examples of the polymerization initiator include a thermal polymerization initiator, a photopolymerization initiator, and others.

The thermal polymerization initiator is a compound that generates active species such as radicals or cations. Examples of the thermal polymerization initiator include azo compounds such as 2,2'-azobis(butyronitrile) (AIBN), peroxides such as benzoyl peroxide (BPO), and others. As the thermal cation polymerization initiator, a benzenesulfonate ester, an alkyl sulfonium salt, or the like is used.

As for the photopolymerization initiator, in the case of an epoxy resin, a photo-cation polymerization initiator is preferably used. When the photo-cation polymerization initiator is mixed into the epoxy resin and irradiated with light, the photo-cation polymerization initiator is decomposed to generate an acid, and the acid causes the polymerization of the epoxy resin and advances the curing reaction. The photo-cation polymerization initiator has the effects of causing less volume contraction at the time of curing, not suffering from oxygen inhibition, and providing high storage stability.

Examples of the photo-cation polymerization initiator include aromatic diazonium salts, aromatic iodonium salts, aromatic sulfonium salts, metallocene compounds, silanol-aluminum complexes, and others. In addition, as a polymerization initiator, a photoacid generator having the function of generating an acid with light irradiation, can also be used. Examples of the photoacid generator include onium salts such as ionic sulfonium salt series and iodonium salt series that act as an acid initiating cation polymerization and are composed of a cation part and an anion part, and others. They may be used singly or in a combination of two or more thereof.

The additive amount of the polymerization initiator may vary depending on the material used, but is preferably 0.5 parts by mass or more and 10 parts by mass or less, more preferably 1 part by mass or more and 5 parts by mass or less to the entire sealing member (100 parts by mass). With the additive amount within the foregoing preferred range, it is possible to properly advance the curing, reduce the residual uncured material, and prevent excess outgassing.

The drying agent (also called hydroscopic agent) is a material that has the function of sucking water physically or chemically and taking up moisture. The inclusion of the drying agent in the sealing member further enhances moisture resistance and reduces the influence of outgassing.

The drying agent is not limited in particular and can be selected as appropriate in accordance with the purpose. However, the drying agent is preferably in a particle state. Examples of the drying agent include inorganic water-absorbing materials such as calcium oxide, barium oxide, magnesium oxide, magnesium sulfate, sodium sulfate, calcium chloride, silica gel, molecular sieve, and zeolite. Among them, zeolite with high moisture absorbency is preferred. They may be used singly or in a combination of two or more thereof.

The curing accelerator (also called curing catalyst) is a material that accelerates the curing rate, and is mainly used for thermosetting epoxy resins.

The curing accelerator is not limited in particular and can be selected as appropriate in accordance with the purpose. Examples of the curing accelerator include tertiary amines or tertiary amine salts such as DBU (1,8-diazabicyclo(5,4,0)-undecene-7), DBN (1,5-diazabi-cyclo(4,3,0)-nonene-5), imidazole series such as 1-cyanoethyl-2-ethyl-4-methylimidazole and 2-ethyl-4-methylimidazole, and phosphines or phosphonium salts such as triphenylphosphine and tetraphenylphosphonium tetraphenylborate, and others. They may be used singly or in a combination of two or more thereof.

The coupling agent is not limited in particular as far as it is a material that has the effect of enhancing molecular binding force, and can be selected as appropriate in accordance with the purpose. Examples of the coupling agent include silane coupling agents. Specifically, examples of the coupling agent include silane coupling agents such as 3-glycidoxypropyltrimethoxysilane, 3-glycydoxypropylmethyldimethoxysilane, 3- glycydoxypropyl-methyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, and 3-methacryloxypropyltrimethoxysilane. They may be used singly or in a combination of two or more thereof.

In the present invention, a sheet-like adhesive can be used.

The sheet-like adhesive is obtained by forming a resin layer on a sheet in advance. The sheet can be made of glass, a film with high gas barrier property, or the like. The sheet may be made of only a resin. The sheet-like adhesive can be stuck to a sealing film. The sealing film can have a structure with a hollow part thereon and the sheet-like adhesive can be stuck to the device.

A distance (d1) between an end portion of the solar cell element and an end portion of the adhesive layer is preferably 0.5 mm or more and 2 cm or less. The end portion of the solar cell element refers to the outer portion of the solar cell element. For example, if the solar cell element is square in shape, the portion on the edge of the square constitutes the end portion of the solar cell element. The end portion of the adhesive layer refers to the outermost edge portion of the adhesive layer. The distance d1 refers to the shortest distance between the edge portion of the solar cell element and the end portion (the edge portion opposite to the solar cell element) of the adhesive layer. The distance d1 is preferably 1 mm or more, preferably 2 mm or more. However, the distance d1 can be adjusted as appropriate depending on the size of the solar cell element. If the solar cell element is square in shape and the length of the long side is defined as l, the distance d1 may be 0.011 or more and 0.5l or less, and may be 0.05l or more and 0.2l or less.

### Sealant Layers (Main Body Parts) 14, 24, and 34

The sealant layer (main body part) refers to a layer that is formed so as to cover the adhesive layer and prevent intrusion of water and the like into the solar cell element. As distinguished from the sealing part, this layer is described herein as a sealant layer or a main body part. The sealant layer preferably covers the solar cell element and the adhesive layer. For example, the sealant layer is arranged to face the support body so as to sandwich the solar cell element including the electrode between the sealant layer and the photoelectric conversion layer. The sealant layer may be made of a sealant film. The sealant layer is not limited in particular in shape, structure, size, and type (material), and can be selected as appropriate in accordance with the purpose. The sealant layer may be a thin film-type or a film type.

The material of the sealant layer may be similar to the material of the adhesive layer. Other examples of the material of the sealant layer include a barrier layer formed on the surface of a resin base for preventing the passage of water and oxygen. The barrier layer may be formed on either or both surfaces of the base. In the latter case, the material of the resin base is not limited in particular. Examples of the material of the resin base include polyolefin resins such as homopolymers or copolymers of ethylene, propylene, and butene, amorphous polyolefin resins such as cyclic polyolefin, polyester resins such as polyethylene terephthalate (PET) and polyethylene naphthalate (PEN), polyamide resins such as nylon 6, nylon 66, nylon 12, and copolymerized nylon; ethylene-vinyl acetate copolymer partial hydrolysate (EVOH); polyimide resins, polyether imide resins, polysulfone resins, polyether sulfone resins, polyether ether ketone resins, polycarbonate resins, polyvinyl butyral resins, polyarylate resins, fluorine resins, acrylic resins, biodegradable resins, and others. Among them, polyester resins are preferred, and polyethylene terephthalate (PET) and polyethylene naphthalate (PEN) are preferred in particular, from the viewpoints of heat resistance and transparency. The resin base may be formed of one kind of resin material or may be formed of two or more kinds of resin materials.

The resin base may include other materials such as an inorganic filler for improving the durability of the solar cell module. The inorganic filler is not limited in particular. Examples of the inorganic filler include silica, mica, talc, clay, bentonite, montmorillonite, kaolinite, wollastonite, calcium carbonate, titanium oxide, alumina, barium sulfate, potassium titanate, glass fiber, and others. The inorganic filler mixed in the resin base may be of one kind or two or more kinds.

The barrier layer has the main component such as a metal oxide, a metal, or a mixture of a polymer and a metal alkoxide. Examples of the main component of the barrier layer include aluminum oxide, silicium oxide, aluminum, and others. Examples of the polymer include polyvinyl alcohol, polyvinylpyrrolidone, methylcellulose, and others. Examples of the metal alkoxide include tetraethoxysilane, tri-isopropoxyaluminum, 3-glycidoxypropyltrimethoxysilane, 3-mercaptopropyltrimethoxysilane, 3-isocyanatopropyltriethoxysilane, and others.

The barrier layer may be transparent or opaque. In addition, the barrier layer may be a single layer of a combination of some of the foregoing materials or may have a laminated structure of a plurality of layers. The method for forming the barrier layer can be a known method, and for example, vacuum film forming methods such as sputtering, and coating methods such as dipping, roll coating, screen printing, spraying, and gravure printing can be used. The thickness of the main body part of the sealant layer may be within the range usually used in the relevant technology. For example, the thickness can be set as appropriate within a range of 0.05 to 1 mm.

The sealant layer preferably covers the entire adhesive layer. The sealant layer is further preferably made larger than the adhesive layer for preventing the intrusion of water and oxygen.

A distance (d2) between the end portion of the adhesive layer and an end portion of the sealant layer is preferably 0.2 mm or more and 1 cm or less. The end portion of the adhesive layer is as described above. The end portion of the sealant layer refers to the outermost edge portion of the sealant layer. The distance between the end portion of the adhesive layer and the end portion of the sealant layer refers to the shortest distance between the end portion of the adhesive layer and the end portion of the sealant layer. The distance d2 is preferably 0.5 mm or more, more preferably 1 mm or more. Although the upper limit varies depending on the size and use purpose of the solar cell, the distance is preferably 1 cm or less, preferably 5 mm or less, more preferably 4 mm or less because the excessively long distance uselessly makes the solar cell (device) too large or makes the parts other than the solar cell element too large.

### Sealing Parts 15, 25, and 35

The sealing parts 15, 25, and 35 are parts that are provided in an end region of the sealant layer to cover the end region. The end region of the sealant layer refers to the outer edge portion of the sealant layer. The sealing part is a part that is provided to more strongly shut off water and oxygen from the outer peripheral portion of the sealant layer. The sealing part is made separately from the sealant layer. The material of the sealant may be identical to that of the sealant layer or may be identical to that of the adhesive. The shape of the sealing part is not limited in particular. As an example, the sealing part is shaped so as to cover the contact point between the end portion of the sealant layer and the support body. The method for forming the sealing part can be a known method such as coating, in accordance with the material.

The sealing part overlaps and extends beyond the top of the sealant layer. The sealing part may be made large to some extent that can prevent the intrusion of water and oxygen. The width of the sealing part (the distance from the center of the solar cell element to outside) is preferably 2 mm or more, more preferably 3 mm or more. The width may be 3 cm or less, may be 2 cm or less, may be 1.5 cm or less, or may be 5 mm or less.

A distance (d3) between the end portion of the sealant layer and an end portion of the sealing part is preferably 0.5 mm or more and 1.5 cm or less. The end portion of the sealant layer is as described above. The end portion of the sealing part refers to an edge portion of the sealing part on the outer side (the side opposite to the solar cell element). The distance between the end portion of the sealant layer and the end portion of the sealing part refers to the shortest distance between the end portion of the sealant layer and the end portion of the sealing part. The distance d3 is preferably 1 mm or more, more preferably 1.5 mm or more to suppress the intrusion of water and oxygen and closely adhere to the sealant main body without separation. In addition, the distance d3 is preferably 1.5 cm or less, preferably 1 cm or less, more preferably 5 mm or less because the excessively long distance uselessly makes the solar cell (device) too large or makes the parts other than the solar cell element too large.

Further, the sealing part is preferably made opaque so as to be easily differentiated from the sealant layer (the main body part). The method for making the sealing part opaque is not limited in particular. Example of the method include adding a filler usable in the adhesive layer and the sealant layer (the main body part) and adding a publicly known pigment or die.

In the cross-sectional view, the cross-section shape of the sealing part is rounded. However, the cross-section shape of the sealing part may be a flat shape in parallel to the support body. The thickness of the sealing part may be equal to or smaller than the thickness of the sealant layer.

### Working Example 1

An ITO-included glass substrate (25 mm × 24.5 mm, Geomatec Co., Ltd.) was subjected to ultrasonic cleaning for 15 minutes each with 2-propanol, acetone, Semico Clean 56 (product name of a display cleaning liquid produced by Furuuchi Chemical Corporation), water, and 2-propanol in this order, and then subjected to plasma treatment. Then, as an electron transport layer, 300 µL of a water-soluble SnO2 colloid solution (obtained by diluting a 15% SnO2 colloid solution with pure water at a ratio of 1:1 and passing through a PTFE filter) was dropped onto a substrate and subjected to spin-coating (3000 revolutions for 20 seconds) to form a film, and the film was dried by heating at 150°C for 30 minutes. The substrate was moved to a globe box, and as a perovskite precursor solution, CsI, MABr (methylammonium bromide, CH5N HBr), PbBr₂, PbI₂, and FAI (formamidine hydroiodide, CH4N2 HI) was dissolved in a mixed solvent of DMF and DMSO (at a volume ratio of 10:3) to adjust a solution with an intensity of 1.05 M. This solution was passed through a PTFE filter, then 190 µL of the solution was applied to the substrate with the electron transport layer and was subjected to spin coating (at 1000 rpm with a one-second slope for 10 seconds, and then at 3000 rpm with a five-second slope for 20 seconds), during which 300 µL of chlorobenzene was dropped. The obtained device was then heated at 150°C for 10 minutes. Subsequently, 72.3 mg of a hole transport material Spiro-OMeTAD, 13.5 mg of [tris(2-(1H-pyrazole-1-yl)-4-tert-butylpyridine)cobalt(III)tris(bis(trifluoromethylsulfonyl)i mide)] (FK209, FUJIFILM Wako Pure Chemical Corporation), 28.8 µL of 4-t-butylpyridine, and 9.1 mg of LiTFSI were dissolved in 1 mL of chlorobenzene, and the solution was stirred for 30 minutes, and then passed through a PTFE filter. Then, 90 µL of the solution was spin-coated on the perovskite layer (at 4000 rpm with a four-second slope for 30 seconds, then stopped with a four-second slope), and then dried by heating at 70°C for 30 minutes. Finally, 80 nm of gold was formed by vacuum deposition, thereby obtaining a perovskite solar cell element.

As the adhesive, 1.0 g of hydrotalcite was mixed with an epoxy resin produced by Epoch (4.0 g of E-01-001 base resin and 2.0 g of a curing agent), and was applied onto the perovskite solar cell element by spin-coating (1000 revolutions for 120 seconds), and an unnecessary portion was removed by acetone. Then, an aluminum oxide-deposited PET film (product name: BarriaLox^{®} produced by Toray Industries, Inc.) cut into a size larger than the coating area of the adhesive described above was stuck to the solar cell element, and heated at 80°C for one hour.

A one-component epoxy adhesive (Nagase ChemteX UV resin XNR5516Z-B1) was applied to the outer peripheral portion of the film by screen printing and cured by UV irradiation to form a sealing part, whereby a solar cell device as illustrated in FIG. 1 was produced. The width of the sealing part was 3.3 mm (the same width in the horizontal and vertical directions), the distance d1 was 2.0 mm, the distance d2 was 0.3 mm, and the distance d3 was 1.0 mm.

The solar cell device was measured for solar cell characteristics by using a solar simulator (SM-250PV produced by Bunkoukeiki Co., Ltd., with a light amount of 100 mW/cm²). As a result, an open voltage of 1.10 V, a short-circuit current density of 22.1 mA/cm², a form factor of 0.72, and a conversion efficiency of 17.5% were obtained.

Then, the solar cell device was put into a constant temperature and humidity tester at 60°C and 90%RH to conduct a durability test. The maintenance factor of the initial characteristics after 500 hours was 91%.

### [Experimental Example 1]

A solar cell device was produced in the same manner as in Working Example 1 except that no sealing resin was provided at the outer peripheral portion of the film in Working Example 1, and was evaluated for solar cell characteristics. As a result, an open voltage of 1.10 V, a short-circuit current density of 22.0 mA/cm², a form factor of 0.72, and a conversion efficiency of 17.4% were observed, which are equivalent to those of Working Example 1. Then, the solar cell device was tested for durability at a constant temperature and high humidity tester in the same manner as in Working Example 1 to measure the maintenance factor after 500 hours. The result was 42% which made it clear that the device structure of the present invention is excellent in durability.

### Working Example 2

An adhesive layer (first layer) of the same size as the perovskite solar cell element in Working Example 1 was formed on the solar cell element, and the top of the adhesive layer was covered with a sealant layer (first layer). An adhesive layer (second layer) was formed on the entire sealant layer by covering with the same adhesive as above, and the top of the adhesive layer was covered with the same sealant layer (second layer) as the first layer.

A sealant was applied to the outer peripheral portion of the second layer in the same manner as in Working Example 1 and cured to produce a solar cell device as illustrated in FIG. 3.

The width of the sealing part was 3.4 mm (the same in the horizontal and vertical directions), the distance d1 was 1.9 mm, the distance d2 was 0.4 mm, and the distance d3 was 1.1 mm.

This device was measured for solar cell characteristics. As a result, an open voltage of 1.09 V, a short-circuit current density of 22.2 mA/cm², a form factor of 0.72, and a conversion efficiency of 17.4% were observed. Then, the solar cell device was tested for durability at a constant temperature and high humidity tester in the same manner as in Working Example 1 to measure the maintenance factor after 500 hours. The result was 92% which made it clear that the device structure of the present invention is excellent in durability.

### Working Example 3

An adhesive layer (first layer) of the same size as the perovskite solar cell element in Working Example 1 was formed on the solar cell element, and the top of the adhesive layer was covered with a sealant layer (first layer). An adhesive layer (second layer) was formed on the entire sealant layer by covering with the same adhesive as above, and the top of the adhesive layer was covered with the same sealant layer (second layer) as the first layer.

A sealant was applied to the outer peripheral portion of the second layer in the same manner as in Working Example 1 and cured to produce a solar cell device as illustrated in FIG. 4.

The width of the sealing part was 3.9 mm (the same in the horizontal and vertical directions), the distance d1 was 2.0 mm, the distance d2 was 0.7 mm, and the distance d3 was 1.2 mm.

This device was evaluated for solar cell characteristics. As a result, an open voltage of 1.09 V, a short-circuit current density of 22.1 mA/cm², a form factor of 0.72, and a conversion efficiency of 17.3% were observed. Then, the solar cell device was tested for durability at a constant temperature and high humidity tester in the same manner as in Working Example 1 to measure the maintenance factor after 500 hours. The result was 93% which made it clear that the device structure of the present invention is excellent in durability.

### [Experimental Example 2]

A solar cell device was produced in the same manner as in Working Example 2 except that no sealing resin was provided at the outer peripheral portion of the film in Working Example 2, and was evaluated for solar cell characteristics. As a result, an open voltage of 1.09 V, a short-circuit current density of 22.0 mA/cm², a form factor of 0.72, and a conversion efficiency of 17.3% were observed, which are equivalent to those of Working Example 2. Then, the solar cell device was tested for durability at a constant temperature and high humidity tester in the same manner as in Working Example 1 to measure the maintenance factor after 500 hours. The result was 510 which made it clear that the device structure of the present invention is excellent in durability.

### [Experimental Example 3]

A solar cell device was produced in the same manner as in Working Example 3 except that no sealing resin was provided at the outer peripheral portion of the film in Working Example 3, and was evaluated for solar cell characteristics. As a result, an open voltage of 1.10 V, a short-circuit current density of 22.0 mA/cm², a form factor of 0.71, and a conversion efficiency of 17.2% were observed, which are equivalent to those of Working Example 3. Then, the solar cell device was tested for durability at a constant temperature and high humidity tester in the same manner as in Working Example 1 to measure the maintenance factor after 500 hours. The result was 48% which made it clear that the device structure of the present invention is excellent in durability.

### Working Example 4

A solar cell was produced in the same manner as in Working Example 1 except that a carbon black was mixed into the sealing part. It was absolutely recognized that the sealing part became blackened and was formed so as to cover the end portion of the sealant layer without a gap.

From the above, it is possible to produce a highly durable device by the sealing structure of the present invention.

### INDUSTRIAL APPLICABILITY

The present invention can be utilized in technical fields of solar cells and others.

### REFERENCE SIGNS LIST

1, 2, 3, 6, 7, 8 Solar cell
4, 5 Perovskite solar cell element
11, 21, 31, 61, 71, 81 Support body
12, 22, 32, 62, 72, 82 Perovskite solar cell element
13, 23, 33, 63, 73, 83 Adhesive layer
14, 24, 34, 64, 74, 84 Sealant layer
15, 25, 35 Sealing part
40, 50 Transparent electrode
46, 56 Electron transport layer
47, 57 Photoelectric conversion layer (perovskite layer)
48, 58 Hole transport layer
49, 59 Back electrode

## Claims

1. A solar cell comprising:
a support body;
a solar cell element provided on the support body;
an adhesive layer covering the solar cell element;
a sealant layer covering the adhesive layer; and
a sealing part that is provided in an end region of the sealant layer and covers the end region, wherein
the solar cell element includes:
an electrode;
a photoelectric conversion layer containing a perovskite compound; and
a back electrode, in this order.

2. The solar cell according to claim 1, wherein a distance (d1) between an end portion of the solar cell element and an end portion of the adhesive layer is 0.5 mm or more and 2 cm or less.

3. The solar cell according to claim 1, wherein a distance (d2) between an end portion of the adhesive layer and an end portion of a portion of the sealant layer is 0.2 mm or more and 1 cm or less, the portion covering the adhesive layer.

4. The solar cell according to claim 1, wherein a distance (d3) between an end portion of the sealant layer and an end portion of the sealing part is 0.5 mm or more and 1.5 cm or less.

5. The solar cell according to claim 1, wherein the sealing part is opaque.
